# EUROPÄISCHE PATENTSCHRIFT

(11) **EP 1 716 521 B1**
(45) Veröffentlichungstag und Bekanntmachung des Hinweises auf die Patenterteilung: **02.11.2016**
(21) Anmeldenummer: 05701322.9
(22) Anmeldetag: 03.02.2005
(51) Int. Cl.: B41F 17/00, B41M 1/22, H01L 51/00, G06K 19/077, H05K 3/12

(54) **APPLIKATION VON RFID-CHIPS**
APPLICATION OF RFID LABELS
APPLICATION DE PUCES RFID

(30) Priorität: 13.02.2004 DE 102004007457
(43) Veröffentlichungstag der Anmeldung: 02.11.2006
(73) Patentinhaber: Manroland Sheetfed GmbH, 63075 Mühlheim (DE)
(72) Erfinder: WALTHER, Thomas, 65719 Hofheim (DE); BAUMANN, Reinhard, 82152 Krailling (DE); DILLING, Peer, 86316 Friedberg (DE); WEISS, Robert, 86368 Gersthofen (DE)
(74) Vertreter: Stahl, Dietmar
(86) Internationale Anmeldenummer: PCT/EP2005/001051
(87) Internationale Veröffentlichungsnummer: WO 2005/086087

(56) Entgegenhaltungen:
- WO-A-02/096168
- US-A- 5 656 081

## Beschreibung

Die Erfindung betrifft ein Verfahren zur Herstellung von RFID Etiketten gemäß dem Oberbegriff von Anspruch 1.

Die Erfindung beschreibt verschiedene Verfahren zur Herstellung von RFID (Radio Frequency Identification) Etiketten, auch Smart Labels genannt. Basis der intelligenten Etiketten (RFID, Smart Labels) ist die sogenannte Transponder Technologie. Ihr großer Vorteil liegt in der Funkverbindung zwischen dem Etikett und einem Lesegerät. Das kann den maschinellen Datenerfassungsvorgang extrem beschleunigen, weil die Lesegeräte keine optische Verbindung zu den Etiketten mehr brauchen. Damit kann z.B. der Inhalt einer Schachtel oder einer ganzen Palette fehlerfrei erfasst werden. Auch können in den intelligenten Etiketten Sicherheitscodes hinterlegt werden, wodurch Packungsfälschungen (z.B. Pharmaindustrie) oder Diebstähle eindeutig identifiziert werden können.

Ein System zur drahtlosen Identifikation besteht aus zwei Komponenten: Den RFID Etiketten (Smart Labels), die an den Waren angebracht werden und dem Schreib- / Lesegerät mit dem Daten aus dem Etikett ausgelesen oder übertragen werden können. Die Transponder speichern je nach Ausführung einfache Identifikationsnummer bis zu komplexen Daten (z.B. Verfallsdatum, Herstellungsort und - tag, Verkaufspreise etc.). Auch können Meßdaten gespeichert werden. Die Transponder bestehen meist aus einer integrierten Schaltung, einer Antenne und weiteren passiven Komponenten. In der Art der Energieversorgung wird zwischen aktive und passive Transponder unterschieden. Besitzt das Etikett eine Energieversorgung, z.B. in Form einer Batterie, so spricht man von einem aktiven System. Als passive wird ein Transponder bezeichnet, wenn er über ein externes, magnetisches oder elektrisches, Feld mit Energie versorgt wird.

Der Transponder IC, der mit der Antenne des mobilen Datenträgers verbunden ist, übernimmt das Senden / Empfangen der Daten. Bei passiven RFID Transpondern ist in der Regel die gesamte Intelligenz und Funktionalität in diesem Schaltkreis integriert.
Einige Typen enthalten darüber hinaus einen On- Chip Resonanz Kondensator für den Schwingkreis, so dass außer einer Antennenspule keine weiteren externen Komponenten erforderlich sind. Der oder die benötigten Kondensatoren können auch durch drucktechnische Verfahren erzeugt werden. Klassische und bekannte Verfahren für die Herstellung der RFID Etiketten sind die Lamination einer beschichten Folie auf das Etikett, das Drucken der Antenne mittels Siebdruckverfahren oder die Herstellung mittels Tintenstrahlverfahren.

Aus der US 5,656,081 A ist eine Druckmaschine zum Drucken von Komponenten von elektrischen Schaltkreisen direkt auf ein Substrat mittels einer elektrisch leitfähigen Flüssigkeit bekannt. Das Drucken erfolgt im Tiefdruckverfahren mit spezieller Gravur der Druckform auf bahnförmigem Material. Die Schaltkreise werden als Vielzahl von Einzelelementen über der Gesamtfläche der Bahn nebeneinander angeordnet angebracht und von der Bahn zur Vereinzelung und zum Aufstapeln abgeschnitten oder als Bahn wieder aufgewickelt.

Beim Anbringen von Warensicherungsetiketten, z.B. auch RFID-Etiketten, wird bislang ein einzelnes Warensicherungselement auf einem Teilelement, z.B. einem selbstklebenden Etikett kleiner Flächenausdehnung, erzeugt und auf diesem Teilelement auf der Ware, deren Verpackung oder einer Transportverpackung angebracht. Die Erzeugung von Warensicherungselementen kann allerdings, wie oben beschrieben, auch durch direkten Druck auf die Verpackung selbst erfolgen. Um die Applikation der Warensicherungselemente zu erleichtern, ist es vorgesehen, die Warensicherungselemente direkt auf einzelne Verpackungen, Verpackungselemente oder auf Teile der Verpackung aufzubringen. Beim Druck von Verpackungen besteht ein Bogen aus mehreren sogenannten Nutzen. Jeder Nutzen beinhaltet eine Verpackung oder einen Teil einer Verpackung, ein Verpackungselement. Diese Produktion von mehreren Nutzen auf einem Bogen erfordert, dass nachträglich die Nutzen voneinander getrennt werden. Diese Trennung der Nutzen kann für die Anbringung der Warensicherungsetiketten genutzt werden. Nachdem der gesamte Bogen bedruckt worden ist, beinhaltet er die vorgedruckten sensorischen Elemente des Warensicherungselementes, z.B. Teile eines RFID-Etiketts. Die Anbringung der auf die externe Sensorik ansprechenden Elemente jedes einzelnen Warensicherungselementes, z.B. eines Chips, soll dann noch nachträglich erfolgen. Die Anbringung wird dadurch erschwert, dass die Nutzen auf dem Bogen platzsparend angebracht und dadurch in unterschiedlichen Lagen und in mehreren Reihen angebracht sind.

Aufgabe der vorliegenden Erfindung ist es, die benötigten Teile in einfacher Weise mit geringem technischem Aufwand auf einer Verpackung anzubringen.

Gelöst wird diese Aufgabe durch die kennzeichnenden Merkmale von Anspruch 1. Weiterbildungen der Erfindung ergeben sich aus den jeweiligen Unteransprüchen.

Erfindungsgemäß ist vorgesehen, dass zumindestens Teile der für die Funktion benötigten Antenne und/oder des Schwingkreises im Offsetdruck auf dem Bedruckstoff appliziert werden bzw. dass zumindest ein Teil der für die Funktion benötigten Antenne und des Schwingkreises direkt oder indirekt mit einer Hochdruckplatte appliziert wird. Nach dem Druck muss dann nur noch der Chip, der meist ungehaust ist, durch ein Klebe- oder Lötverfahren aufgebracht werden.

Beim Design der Antenne sind folgende Größen von Interesse: Die Induktivität, die Spulenfläche, der ohmsche Widerstand und die Koppelkapazität zwischen den Windungen. Abweichungen von den Kennwerten können dazu führen, dass der Kontakt

Bogen bedruckt worden ist, beinhaltet er die vorgedruckten sensorischen Elemente des Warensicherungselementes, z.B. Teile eines RFID-Etiketts. Die Anbringung der auf die externe Sensorik ansprechenden Elemente jedes einzelnen Warensicherungselementes, z.B. eines Chips, soll dann noch nachträglich erfolgen. Die Anbringung wird dadurch erschwert, dass die Nutzen auf dem Bogen platzsparend angebracht und dadurch in unterschiedlichen Lagen und in mehreren Reihen angebracht sind.

### [Aufgabe der Erfindung]

Aufgabe der vorliegenden Erfindung ist es, die benötigten Teile in einfacher Weise mit geringem technischem Aufwand auf einer Verpackung anzubringen.

Gelöst wird diese Aufgabe durch die kennzeichnenden Merkmale von Anspruch 1 bzw. 12 in Verbindung mit Anspruch 25. Weiterbildungen der Erfindung ergeben sich aus den jeweiligen Unteransprüchen.

### [Beispiele]

Erfindungsgemäß ist vorgesehen, dass zumindestens Teile der für die Funktion benötigten Antenne und/oder des Schwingkreises im Offsetdruck auf dem Bedruckstoff appliziert werden bzw. dass zumindest ein Teil der für die Funktion benötigten Antenne und des Schwingkreises direkt oder indirekt mit einer Hochdruckplatte appliziert wird. Nach dem Druck muss dann nur noch der Chip, der meist ungehaust ist, durch ein Klebe- oder Lötverfahren aufgebracht werden.

Beim Design der Antenne sind folgende Größen von Interesse: Die Induktivität, die Spulenfläche, der ohmsche Widerstand und die Koppelkapazität zwischen den Windungen. Abweichungen von den Kennwerten können dazu führen, dass der Kontakt zwischen dem Lese- / Schreibgerät und dem Transponder nicht zustande kommt. Die Resonanzfrequenz muss mit einer hohen Güte erreicht werden, so dass höchste Ansprüche an die Druckqualität gestellt werden.

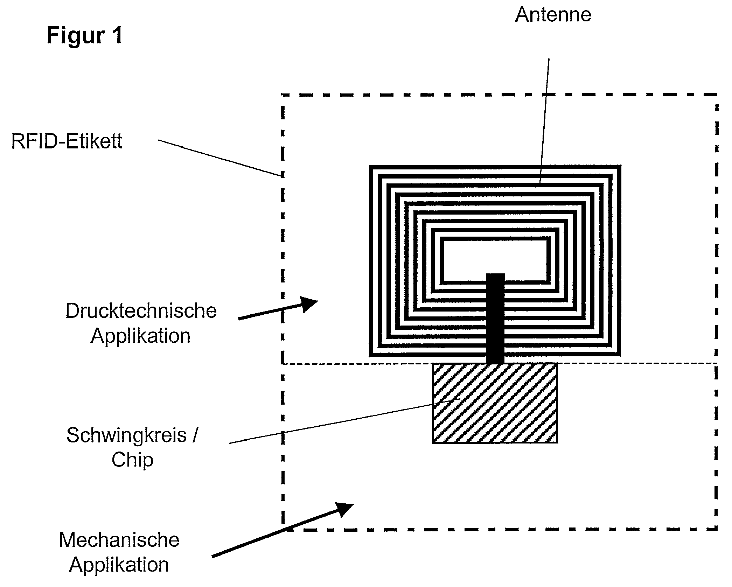

Nach der Erfindung wird eine Metallfarbe oder leitfähige Paste über eine wasserlos Offsetplatte oder eine Nassoffsetplatte über das Gummituch auf den Bedruckstoff innerhalb einer Bogen- oder Rollenoffsetdruckmaschine übertragen wird. Die gedruckten Linien bilden die Antenne und gegebenenfalls dem gesamten Schwingkreis, der Chip wird später erforderlichenfalls aufgelötet oder aufgeklebt. Der Bedruckstoff, auf den die Bestandteile des Schwingkreises aufgedruckt werden, kann ein Faserstoff (Papier, Vlies u.a.), ein Gewebe aus Natur- oder Kunstfasern oder eine Kunststofffolie sein. Eine Draufsicht auf ein nach der Erfindung hergestelltes Etikett zeigt die schematisierte Figur 1.

Ein wegschlagender Bedruckstoff, z.B. wenn es sich bei diesem um ein Papier oder einen anderen Faserstoff handelt, kann vorbehandelt sein, um ein Wegschlagen der leitfähigen Druckfarbe oder Paste zu vermeiden. Die Vorbehandlung kann ein Lackauftrag oder eine Auftrag einer Vordruckfarbe über ein Flexodruckwerk oder ein Offsetdruckwerk sein. Möglich ist auch, dass auf den Etikettenrücken eine Folie kaschiert ist oder das Etikett auf den Rücken schon durch den Hersteller vorbehandelt ist. Bei einem sehr starken Wegschlagen der Druckfarbe in den Bedruckstoff kann es zu einer Veränderung der Induktivität durch die dritte Ebene kommen. Der Auftrag mittels Druckplatte für den Wasserlosen Druck wird gegenüber dem Nassoffset bevorzugt, da das im Nassoffset benötigte Feuchtmittel zu einem Korrodieren der Farbe führen kann und auch die Präzision des Druckes höher ist. Auch können im wasserlosen Offset höhere Auflösungen bzw. feinere Linienstärken gedruckt werden.

Ein Kondensator, der für die Herstellung eines Schwingkreises benötigt wird, kann erzeugt werden, dass zwei Linien eng nebeneinander gedruckt werden, die an den Enden der kürzeren Linie wieder miteinander verbunden sind. Alternativ kann zuerst die Grundlinie gedruckt werden, dann wird ein isolierender Stoff darüber gedruckt und in einem dritten Druckwerk dann die Gegenlinie aufgedruckt. Der Kondensator kann auch in den Chip integriert sein. Andere Schaltkreiselemente-können auch gedruckt werden, z.B. Widerstände durch eine Verjüngung der Linienstärke.

Theoretisch könnte die Kondensatorlinien auf beide Seite des Bedruckstoff gegenüberliegend aufgedruckt werden. Dazu müsste der Bedruckstoff vorher perforiert werden, dass eine Verbindung zwischen zwei gegenüberliegenden Linien beim Farbauftrag entsteht.

Abschließend kann die Antenne und der Schwingkreis mit einem Schutzlack überzogen werden, der den Aufdruck gegen mechanische, chemische oder oxidative Beschädigungen schützt. Alternativ dazu kann eine Schutzfolie aufgezogen werden.

In einem zweiten Verfahren wird ein Klebstoff über ein Druckwerk vorgedruckt, der mit dem Klebstoff bedruckte Bogen mit einer Transferfolie in Kontakt gebracht, die mit einem metallischen oder anderen leitfähigen Stoff beschichtet ist. An den Stellen mit dem aufgebrachten Klebstoff löst sich der leitfähige Stoff von der Trägerfolie und wird auf den Bedruckstoff übertragen. Dieser bildet dann den Schwingkreis, Antenne oder Bestandteile davon.

Als drittes Verfahren kommt ein Auftrag der Linien der Antenne / des Schwingkreises mittels des Flexodruckverfahrens in Betracht. Nachteilig ist jedoch, dass Flexodruckplatte bei nicht exakt justierter Beistellung zu Quetschrändern führen können. Diese Quetschränder würden zu einer Veränderung durch Kapazitätsänderung zu einer Veränderung der Charakteristik des Schwingkreises führen.

Die Komplettierung des RFID-Etiketts mittels des Schwingkreises bzw. eines Chips erfolgt dann durch nachträgliche Applikation mittels Auflöten oder Aufkleben.

Dies wird in dem erfindungsgemäßen Verfahren vorteilhafter Weise so vorgenommen, dass nach dem Teilen eines Bogens in einzelne Nutzen oder in Nutzenblöcke einander einheitlich zugeordnete Elemente entstehen. Bei der Anbringung der Chips können nun die Nutzenteile oder Nutzenblocks so einem Applikationsgerät zugeführt werden, dass die Warensicherungselemente immer in gleicher Position bearbeitet werden können. Damit wird die Applikation der Chips zu den bereits aufgedruckten Teilen der Warensicherungselemente erheblich erleichtert. Die komplettierten Teile können dann leicht an einer Verpackung angebracht werden.

Ebenso ist es möglich die gedruckten Grundelemente direkt auf einer Verpackung anzubringen. Dann kann das RFID-Etikett in der Faltschachtelklebemaschine oder in der Abfüllstation komplettiert werden.

Die RFID-Etiketten können so direkt in die Verpackung oder die Verpackungsteile oder auf Einzelelemente, die auf die Verpackung aufgebracht werden oder diese ergänzen und die nur ein RFID-Etikett tragen, eingebracht werden.

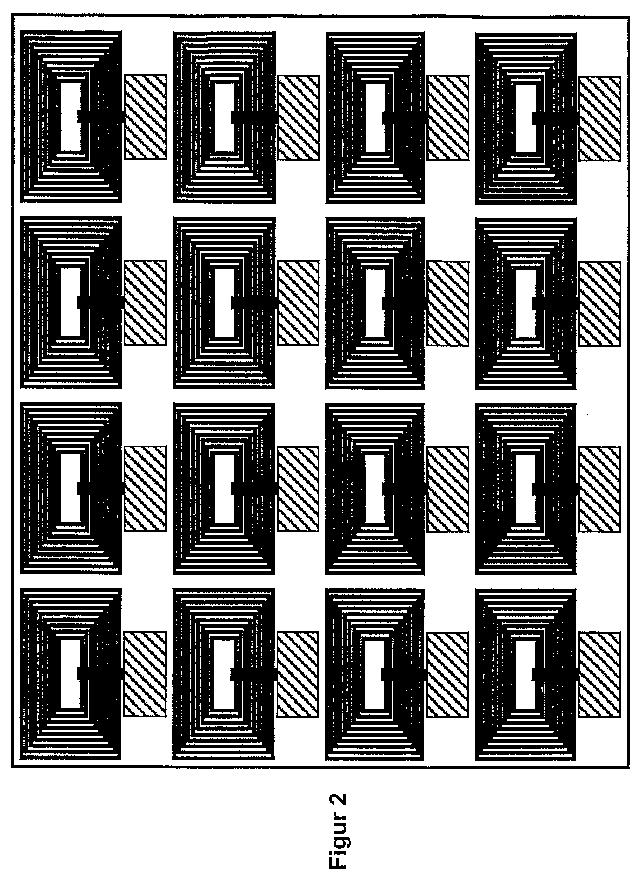

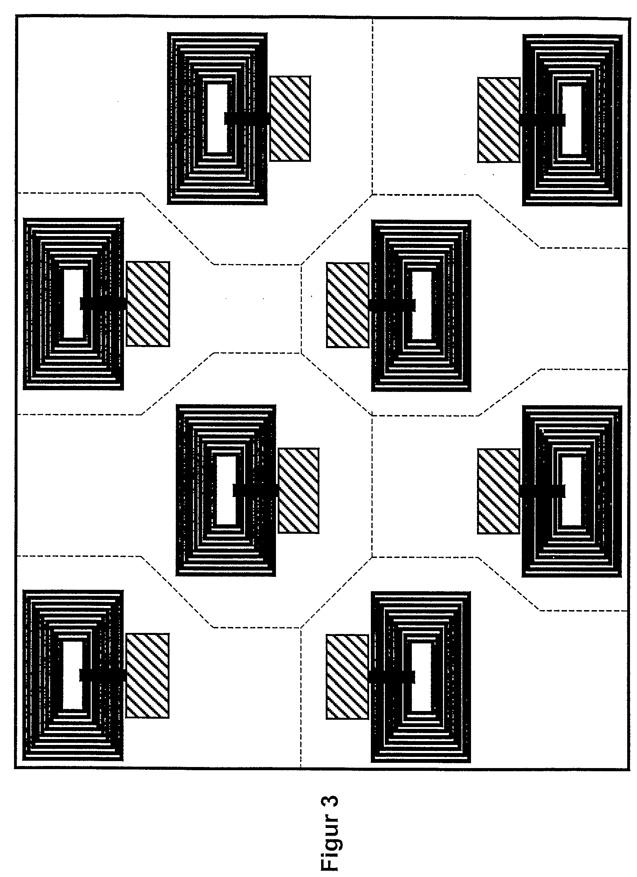

Zur Verdeutlichung sind schematisierte Figuren 2 und 3 zu beachten. Ausgehend davon wird daher folgendes Vorfahren vorgeschlagen:
1. Die Antennen eines RFID-Chips werden zu mehreren Nutzen auf die Bogen aufgedruckt.
2. Die einzelnen Nutzen werden ausgestanzt bzw. geschnitten und vereinzelt.
3. Die einzelnen Nutzen werden in gleicher Orientierung gesammelt.
4. Auf den einzelnen Nutzen oder Nutzenblocks wird dann der Schwingkreis bzw. Chip aufgelötet oder aufgeklebt.

Die Applikation der Schwingkreise bzw. Chips kann so in einer separaten Anlage erfolgen und auf die einzelnen Nutzen bezogen werden. Idealerweise kann die Applikation innerhalb einer Fertigungslinie z.B. in einer Faltschachtelklebemaschine oder auch innerhalb der Abfüllstation erfolgen.

Damit wird vermieden, dass fertigverpackte Waren in einer zusätzlichen Markierstation mit den Warensicherungselementen versehen werden müssen. Vorteilhaft an dem Verfahren ist weiterhin, dass die Antennen bzw. auch weitere Bestandteile des Schwingkreises mehrnutzig bedruckt werden können. Auf einem Einzelnutzen muß nur der Chip appliziert werden. Damit wird eine deutliche Kostenreduktion möglich.

## Patentansprüche

1. Verfahren zur Herstellung eines RFID Etiketts unter Verwendung eines Druckverfahrens, bei dem zumindest ein Teil einer für die Funktion eines RFID Etiketts benötigten Antenne und eines zugehörigen Schwingkreises durch Bogenoffsetdruck auf den Bedruckstoff appliziert wird, wobei für den Druck der Leiterbahnen eine leitfähige Paste oder Druckfarbe verwendet wird, wobei die leitfähigen Druckfarbe metallische Partikel oder Ruß oder Kohlefasern beinhaltet und wobei nach dem Druck der Bestandteile der Antenne / des Schwingkreises ein Schutzlack oder eine Schutzfarbe aufgetragen wird, wobei der Farbauftrag und ein Schutzlack oder eine Schutzfarbe in einer Bogenoffsetmaschine mit Greifertransport oder dass zumindest ein Teil einer für die Funktion eines RFID Etiketts benötigten Antenne und eines zugehörigen Schwingkreises direkt oder indirekt mit einer Hochdruckplatte auf einen Bedruckstoff appliziert wird, wobei die Hochdruckplatte auf einen Plattenzylinder einer Bogenoffsetdruckmaschine aufgespannt wird und der Farbübertrag indirekt über einen Gummizylinder auf den Bedruckstoff erfolgt, und
dass die Herstellung von Antennen bzw. von Teilen der Schwingkreise für RFID Etiketten zu mehreren Nutzen auf einem Bogen verteilt erfolgt und wobei die Herstellung jeweils innerhalb der mehreren Nutzen für Verpackungen oder Verpackungsteile auf einem Bogen verteilt erfolgt.

2. Verfahren nach Anspruch 1, **gekennzeichnet dadurch,**
**dass** die Bestandteile der Antenne / des Schwingkreises auf die Bogenrückseite appliziert werden und der Bogen danach in einer Wendeeinrichtung umstülpt wird.

3. Verfahren nach Anspruch 1, **gekennzeichnet dadurch,**
**dass** es sich bei dem Bedruckstoff um einen Faserstoff oder um eine Folie oder um ein Gewebe aus Natur- und / oder Kunstfasern handelt.

4. Verfahren nach Anspruch 1, **gekennzeichnet dadurch,**
**dass** bei wegschlagenden Bedruckstoffen ein Vorstrich, Vorlackierung oder ein Vordruck mit einem Lack oder einer Vordruckfarbe erfolgt, der die Wegschlageigenschaften verringert.

5. Verfahren nach Anspruch 4, **gekennzeichnet dadurch,**
**dass** der Vorstrich, die Vorlackierung oder der Vordruck mittels eines direkten Hochdruckwerkes oder mittels einer Hochdruckplatte indirekt über einen Gummizylinder oder über ein Offsetdruckwerk appliziert wird.

6. Verfahren nach Anspruch 1, **gekennzeichnet dadurch,**
**dass** zur Herstellung eines kapazitiven Elements (Kondensator) zwei Linien streckenweise nebeneinander gedruckt werden, die an den Enden der kürzeren Linien miteinander verbunden sind, wobei erst die Grundlinie gedruckt wird, dann partiell ein Isolator aufgedruckt wird und in einem dritten Arbeitsschritt dann die Gegenlinie aufgedruckt wird.

7. Verfahren nach Anspruch 1, **gekennzeichnet dadurch,**
**dass** die Herstellung von Antennen bzw. von Teilen der Schwingkreise für RFID Etiketten jeweils innerhalb der mehreren Nutzen für Verpackungen oder Verpackungsteile oder für jeweils ein einzelnes RFID Etikett auf einem Bogen verteilt erfolgt.

8. Verfahren nach Anspruch 7, **gekennzeichnet dadurch,**
**dass** die Nutzen eines Bogens in Blöcken oder einzeln voneinander getrennt werden.

9. Verfahren nach einem der Ansprüche 7 oder 8,
**gekennzeichnet dadurch,**
**dass** die Applikation des Schwingkreises bzw. Chips für ein RFID-Etikett auf den vereinzelten Nutzen oder Nutzenblöcken in einheitlicher Orientierung der Nutzen erfolgt

10. Verfahren nach einem der Ansprüche 7 oder 8,
**gekennzeichnet dadurch,**
**dass** die Applikation des Schwingkreises bzw. Chips für ein RFID-Etikett auf den an einer Verpackung angebrachten Nutzen erfolgt

11. Verfahren nach Anspruch 10, **gekennzeichnet dadurch,**
**dass** die Applikation des Schwingkreises bzw. Chips für ein RFID-Etikett bei der Erstellung der Verpackung z.B. in einer Faltschachtelklebemaschine erfolgt.

12. Verfahren nach Anspruch 10, **gekennzeichnet dadurch,**
**dass** die Applikation des Schwingkreises bzw. Chips für ein RFID-Etikett bei der Befüllung der Verpackung z.B. in einer Abfüllstation erfolgt

## Claims

1. A method for producing an RFID label using a printing method, in which at least a part of an antenna required for the function of an RFID label and of a corresponding oscillating circuit is applied to the printing material using sheet-fed offset printing, wherein a conductive paste or printing ink is used for printing the conductive paths, wherein the conductive printing ink contains metallic particles or carbon black or carbon fibers and wherein a protective varnish or a protective ink is applied after printing the components of the antenna / of the oscillating circuit, wherein the ink application and a protective varnish or a protective ink in a sheet-fed offset press with gripper transport or
that at least a part of an antenna required for the function of an RFID label and of a corresponding oscillating circuit is applied directly or indirectly onto a printing material by means of a letter press plate, wherein the letter press plate is clamped onto a plate cylinder of a sheet-fed printing press and the ink transfer onto the printing material takes place indirectly via a blanket cylinder, and
that the production of antennas or of parts of the oscillating circuits, respectively, for RFID labels takes place so as to be distributed on a sheet to a plurality of panels and wherein the production in each case takes place within the plurality of panels for packaging or packaging parts so as to be distributed on a sheet.

2. The method according to claim 1, **characterized in that** the components of the antenna / of the oscillating circuit are applied to the back side of the sheet and the sheet is then turned inside out in a turning station.

3. The method according to claim 1, **characterized in**
**that** the printing material is a fiber material or a foil or a fabric of natural and/or artificial fibers.

4. The method according to claim 1, **characterized in**
**that**, in the case of penetrating printing material, a pre-coat, pre-varnish or a pre-print with a varnish or a pre-print ink takes place, which reduces the penetration characteristics.

5. The method according to claim 4, **characterized in**
**that** the pre-coat, the pre-varnish or the pre-print are applied indirectly via a blanket cylinder or via a web-fed printing unit by means of a direct letter press unit or by means of a letter press plate.

6. The method according to claim 1, **characterized in**
**that**, for producing a capacitive element (capacitor), two lines, which are connected to one another on the ends of the shorter lines, are printed next to one another in parts, wherein the first base line is printed, an insulator is then imprinted in parts, and the counter line is then imprinted in a third operating step.

7. The method according to claim 1, **characterized in that** the production of antennas or of parts of the oscillating circuits, respectively, for RFID labels in each case takes place within the plurality of panels for packaging or the packaging parts or in each case for an individual RFID label on a sheet.

8. The method according to claim 7, **characterized in**
**that** the panels of a sheet are separated in blocks or separately from one another.

9. The method according to one of claims 7 or 8, **characterized in**
**that** the application of the oscillating circuit or chip, respectively, for an RFID label on the separated panels or panel blocks takes place in a uniform orientation of the panels.

10. The method according to one of claims 7 or 8, **characterized in**
**that** the application of the oscillating circuit or chip, respectively, for an RFID label takes place on the panels, which are attached to a packaging.

11. The method according to claim 10, **characterized in**
**that** the application of the oscillating circuit or chip, respectively, for an RFID label takes place in response to preparing the packaging, e.g. in a folder gluer.

12. The method according to claim 10, **characterized in**
**that** the application of the oscillating circuit or chip, respectively, for an RFID label takes place in response to filling the packaging, e.g. in a filling station.

## Revendications

1. Procédé de fabrication d'une étiquette RFID en utilisant un procédé d'impression dans lequel au moins une partie d'une antenne nécessaire au fonctionnement d'une étiquette RFID et d'un circuit oscillant corrélatif est appliquée par impression offset de feuilles sur le support d'impression, une pâte ou encre d'impression conductrice étant utilisée pour l'impression des circuits imprimés, l'encre d'impression conductrice contenant des particules ou de la calamine ou des fibres de carbone et un vernis chic protecteur ou une encre protectrice étend appliqué après l'impression des composantes de l'antenne/du circuit oscillant,
dans lequel l'application d'encre et un vernis protecteur ou une encre protectrice sont appliqués dans une imprimante offset de feuilles avec un transport par préhenseur ou au moins une partie d'une antenne nécessaire au fonctionnement d'une étiquette RFID et d'un circuit oscillant corrélatif est appliquée directement ou indirectement avec une plaque à haute pression sur un support d'impression, la plaque à haute pression est tendue sur un cylindre porte-plaque d'une machine d'impression offset de feuilles et le transfert d'encre se fait indirectement par l'intermédiaire d'un cylindre en caoutchouc sur le support d'impression et
la fabrication d'antennes ou d'éléments des circuits oscillants pour étiquettes RFID a lieu avec une répartition sur plusieurs copies sur une feuille et la fabrication a lieu respectivement dans plusieurs copies pour des emballages ou éléments d'emballage sur une feuille.

2. Procédé selon la revendication 1, **caractérisé en ce que**
les composantes de l'antenne/du circuit oscillant sont appliquées sur le verso de la feuille et que la feuille est ensuite retournée dans un dispositif de retournement.

3. Procédé selon la revendication 1, **caractérisé en ce**
**qu'**il s'agit en ce qui concerne le support d'impression d'un matériau fibreux ou d'un film ou d'une toile faite de fibres naturelles et/ou artificielles.

4. Procédé selon la revendication 1, **caractérisé en ce que**,
dans le cas de supports d'impression absorbants, une enduction, un vernissage préliminaire ou une impression préliminaire avec un vernis ou une encre d'impression préliminaire qui réduit les propriétés d'absorption a lieu.

5. Procédé selon la revendication 4, **caractérisé en ce que**
l'enduction, le vernissage préliminaire ou l'impression préliminaire est appliqué au moyen d'un groupe à haute pression ou au moyen d'une plaque à haute pression indirectement par l'intermédiaire d'un cylindre en caoutchouc ou par l'intermédiaire d'un groupe d'impressions offset.

6. Procédé selon la revendication 1, **caractérisé en ce que**,
pour fabriquer un élément capacitif (condensateur), deux lignes qui sont reliées ensemble aux extrémités des lignes plus courtes sont imprimées l'une près de l'autre sur un parcours, la ligne de base étant d'abord imprimée puis un isolant étant partiellement imprimé dessus et la ligne conjuguée étant ensuite imprimé dessus dans une troisième étape opératoire.

7. Procédé selon la revendication 1, **caractérisé en ce que**
la fabrication d'antennes ou d'éléments des circuits oscillants pour étiquettes RFID a lieu respectivement dans les plusieurs copies pour les emballages ou éléments d'emballage ou pour respectivement une étiquette RFID individuelle avec répartition sur une feuille.

8. Procédé selon la revendication 7, **caractérisé en ce que**
les copies d'une feuille sont divisées en blocs ou individualisées les unes par rapport aux autres.

9. Procédé selon une des revendications 7 ou 8, **caractérisé en ce que**
l'application du circuit oscillant ou de puces pour une étiquette RFID sur les copies ou blocs de copies individualisés a lieu dans une orientation uniforme des copies.

10. Procédé selon une des revendications 7 ou 8, **caractérisé en ce que**
l'application du circuit oscillant ou des puces pour une étiquette RFID a lieu sur les copies apposées sur un emballage.

11. Procédé selon la revendication 10, **caractérisé en ce que**
l'application du circuit oscillant ou des puces pour une étiquette RFID a lieu lors de la création de l'emballage, par exemple dans une machine à coller des boîtes pliantes.

12. Procédé selon la revendication 10, **caractérisé en ce que**
l'application du circuit oscillant ou des puces pour une étiquette RFID a lieu lors du remplissage de l'emballage, par exemple dans une station de remplissage.
